# EUROPEAN PATENT APPLICATION

(11) **EP 4 848 472 A1**
(43) Date of publication of application: **02.12.2026**
(21) Application number: 25797278.6
(22) Date of filing: 10.04.2025
(51) Int. Cl.: H01P 3/00, H01Q 1/22, H05K 1/18, H01L 23/66

(54) **RADIO FREQUENCY APPARATUS, RADIO DEVICE, AND TERMINAL DEVICE**

(30) Priority: 30.04.2024 CN 202420953082 U
(71) Applicant: Calterah Semiconductor Technology (Shanghai) Co., Ltd, Shanghai 201210 (CN)
(72) Inventor: HUANG, Xuejuan, Shanghai 201210 (CN); WANG, Dian, Shanghai 201210 (CN); CHEN, Zhefan, Shanghai 201210 (CN)
(74) Representative: Balder IP Law, S.L.
(86) International application number: PCT/CN2025/088281
(87) International publication number: WO 2025/228103

(57) **Abstract**

Embodiments of the present disclosure relate to the technical field of signal processing, and provide a radio frequency device, a wireless device, and a terminal device. The radio frequency device includes a chip package having a first surface and a carrier having second and third surfaces opposite to each other. On the first surface, at least one radiating element and a respective first waveguide channel surrounding each of the at least one radiating element are provided. The second surface is configured to be connected to the first surface. A slot penetrating through the second surface and the third surface and corresponding to the respective first waveguide channel is defined on the carrier. The solution can effectively reduce the area on the carrier occupied by a transition structure while ensuring that the transition structure does not significantly affect the transmission performance of radio frequency signals.

## Description

### CROSS REFERENCE TO RELATED APPLICATIONS

The present application claims the benefit of priority to Chinese Patent Application No. 202420953082.0, filed on April 30, 2024, which is incorporated herein by reference in its entirety.

### TECHNICAL FIELD

The present disclosure relates to the technical field of signal processing, and in particular to a radio frequency device, a wireless device, and a terminal device.

### BACKGROUND

The Radiation on Package (RoP) technology involves adding, during packaging, a metal patch having a radiation effect for transmitting and receiving signals. A ring of solder balls is arranged around the radiation patch and connected to an apertured printed circuit board (PCB) to form a metal cavity transition structure, which can transmit radio frequency (RF) signals within the package to an externally connected waveguide antenna.

However, in the solution of transmitting RF signals through the above-mentioned transition structure, in addition to ensuring low loss and wide impedance bandwidth characteristics during signal transmission, it is also necessary to consider how to reduce the area occupied by the transition structure on the PCB.

### SUMMARY

An objective of embodiments of the present disclosure is to provide a radio frequency device capable of effectively reducing an area of a carrier occupied by the transition structure while ensuring that the transition structure does not significantly affect the transmission performance of RF signals.

In a first aspect of the present disclosure, a radio frequency device is provided. The radio frequency device includes a chip package having a first surface and a carrier having second and third surfaces opposite to each other. On the first surface, at least one radiating element and a respective first waveguide channel surrounding each of the at least one radiating element are provided. The second surface is configured to be interfaced with the first surface. A slot penetrating through the second surface and the third surface and corresponding to the respective first waveguide channel is defined on the carrier.

In the radio frequency device provided in the embodiments of the present disclosure, when the first surface of the chip package provided with the at least one radiating element is interfaced to the second surface of the carrier, the first waveguide channels formed on the chip package by a plurality of solder balls disposed around each radiating element are positioned over the carrier, and a slot penetrating through the second surface and the third surface and corresponding to a respective first waveguide channel of the first waveguide channels is defined, so that RF signals can be coupled between the respective first waveguide channel and the slot, thereby realizing the transmission and reception of RF signals and ensuring the transmission performance of RF signals. Moreover, by replacing the guided wave transmission of a conventional waveguide with slot coupling on the carrier, the transition structure can have a smaller size, which can reduce the area on the carrier required by the transition structure, and further can reduce the package size of the chip package on the carrier.

In some embodiments, the radio frequency device further includes a waveguide structure interfaced with the third surface of the carrier. A respective second waveguide channel corresponding to the slot is defined on the waveguide structure.

In some embodiments, the slot has a length greater than or equal to λ/2. where λ is the wavelength of an RF signal propagating in a medium within the slot.

In some embodiments, the slot has a cross-section area smaller than those of the respective first and second waveguide channels.

In some embodiments, the slot is disposed to directly face a waveguide port of the respective first waveguide channel and the waveguide port of the respective second waveguide channel.

In some embodiments, the at least one radiating element is at least one metal patch.

In some embodiments, at least one of the respective first waveguide channel and the respective second waveguide channel is a rectangular waveguide, and the slot has parallel to the long side of the waveguide port of the rectangular waveguide.

In a second aspect of the present disclosure, a wireless device is provided. The wireless device includes the radio frequency device as described above and an antenna disposed on the carrier of the radio frequency device. The antenna is configured to transmit and receive wireless signals.

In a third aspect of the present disclosure, a terminal device is provided. The terminal device includes a device body and the wireless device as described above. The wireless device is disposed on the device body and is configured for at least one of target detection and communication.

### BRIEF DESCRIPTION OF THE DRAWINGS

One or more embodiments are described by way of example with reference to the corresponding figures in the drawings. These exemplary descriptions do not constitute limitations on the embodiments. Elements with the same reference numerals in the drawings represent similar elements. Unless specifically stated otherwise, the drawings do not constitute a limitation on the scale.
FIG. 1 is a schematic diagram of a radio frequency device in the related technologies;
FIG. 2 is a front view of a radio frequency device according to some embodiments of the present disclosure;
FIG. 3 is a top view of the radio frequency device shown in FIG. 2; and
FIG. 4 is a simulation result diagram of return loss of the radio frequency device shown in FIG. 2.

### DETAILED DESCRIPTION OF EMBODIMENTS

To make the objectives, technical solutions, and advantages of the embodiments of the present disclosure clearer, various embodiments of the present disclosure will be described in detail below with reference to the accompanying drawings. However, it should be understood by a person of ordinary skill in the art that, in the various embodiments of the present disclosure, numerous technical details are provided for the purpose of enabling the reader to better understand the present disclosure. However, the technical solutions claimed in the present disclosure can be implemented even without these technical details or with various variations and modifications based on the following embodiments. The division of the following embodiments is for convenience of description and should not constitute any limitation on the specific implementation of the present disclosure. The various embodiments may be combined and cross-referenced with each other on the premise that they are not contradictory to each other.

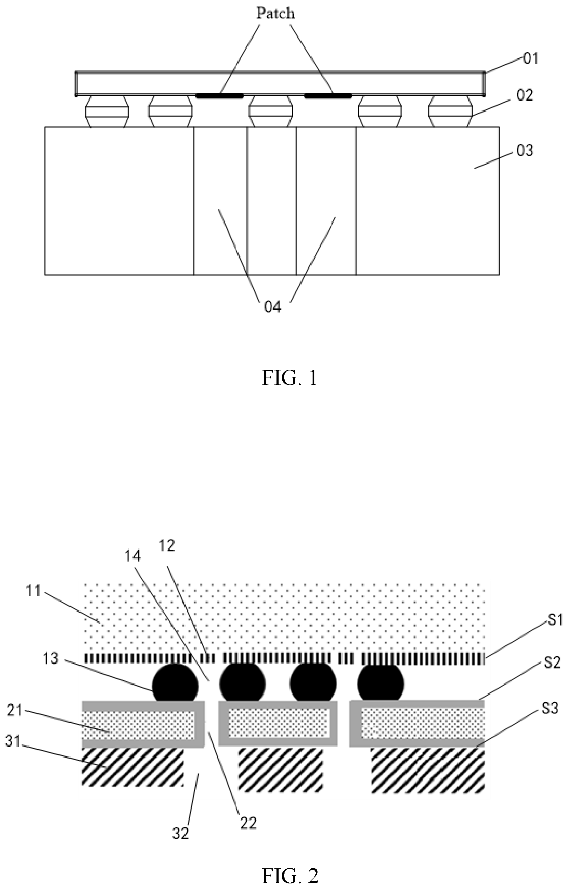

A schematic diagram of a conventional transition structure between a chip package 01 and a waveguide is shown in FIG. 1. The transition structure includes a rectangular cavity (rectangular waveguide) surrounded by solder balls 02 and a waveguide channel 04 (typically also a rectangular waveguide) over a PCB 03. A transmission line in the chip package 01 passes through an E-shaped patch, the rectangular cavity surrounded by the solder balls 02, and the waveguide channel 04 over the PCB 03, and extends to an external waveguide structure (not shown in the figure). Typically, the solder balls 02 are fabricated together with the chip package 01, and therefore the solder balls 02 may be regarded as a part of the chip package 01. The rectangular cavity surrounded by the solder balls 02 may be referred to as a "waveguide structure in the chip package 01". Similarly, the waveguide channel 04 over the PCB 03 may also be referred to as a "PCB waveguide structure". Therefore, RF signals are transmitted in the form of guided waves across the entire transition structure and then transmitted to the external waveguide structure. The dimensions of the external waveguide structure are the same as the dimensions of the PCB waveguide structure.

In the above transition structure, through the waveguide structure surrounded by the solder balls 02 in the chip package 01 and the PCB waveguide structure, electromagnetic signals are transmitted from the chip package 01 to the external waveguide structure in the form of guided waves. Since the rectangular waveguide typically has relatively large dimensions, the transition structure of the chip package 01 needs to occupy a relatively large package area.

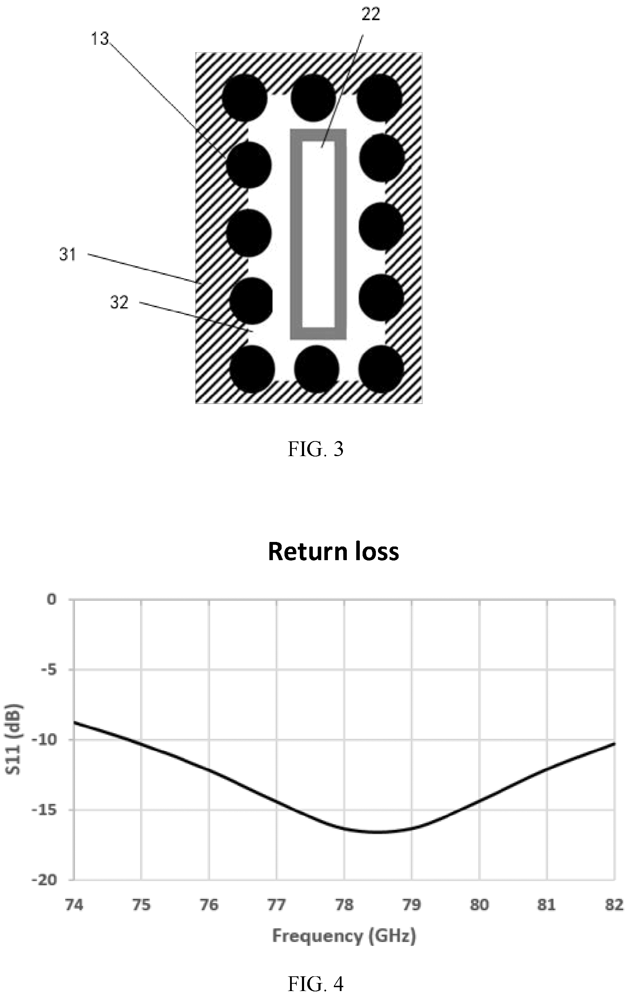

Some embodiments of the present disclosure provide a radio frequency device. The radio frequency device includes a chip package having a first surface and a carrier having second and third surfaces opposite to each other. On the first surface, at least one radiating element and a respective first waveguide channel surrounding each of the at least one radiating element are provided. The second surface is configured to be interfaced with the first surface. A slot penetrating through the second surface and the third surface and corresponding to the respective first waveguide channel is defined on the carrier. For ease of understanding, the following description will be made with reference to the front view and the top view of the radio frequency device shown in FIG. 2 and FIG. 3.

As shown in FIG. 2, the radio frequency device may include: a chip package 11 and a carrier 21.

In some embodiments, the carrier 21 may be configured to carry the chip package 11. The carrier 21 may include a PCB, a flexible printed circuit (FPC), one or more layers of dielectric substrate, one or more wiring boards, and the like, which will not be enumerated one by one herein.

The chip package 11 has a first surface S1 on which at least one radiating element 12 is provided. Each radiating element 12 is surrounded by a respective plurality of solder balls 13, and a space surrounded by the respective plurality of solder balls 13 forms a first waveguide channel 14.

The first surface S1 is a surface of the chip package 11 facing the carrier 21. The radiating element 12 is disposed on the first surface S1 for external transmission and reception of RF signals. A plurality of radiating elements 12 may be provided. A plurality of solder balls 13 are disposed around each respective radiating element 12. The space surrounded by the plurality of solder balls 13 serves as a waveguide channel for the respective radiating element 12 to transmit and receive RF signals on the chip package 11, which is referred to as a first waveguide channel 14.

The carrier 21 has second and third surfaces S2 and S3 opposite to each other. The second surface S2 is configured to be interfaced to the first surface S1 of the chip package 11. After the carrier 21 is connected to the chip package 11, on the second surface S2, at a respective position corresponding to each first waveguide channel 14, a respective slot 22 is defined, and the respective slot 22 penetrates through the second surface S2 and the third surface S3.

The second surface S2 and the third surface S3 are two surfaces of the carrier 21. The second surface S2 is in direct contact with the solder balls 13 to achieve connection of the carrier 21 to the chip package 11. On the second surface S2, slots 22 penetrating through the second surface S2 and the third surface S3 are defined. After interfacing, each of the first waveguide channels 14 directly face or corresponds to a respective slot 22. The design of such a slot structure causes the electromagnetic field to be redistributed at the slots 22 to form a radiation field when the RF signal is transmitted from the first waveguide channels 14 to the slots 22, such that electromagnetic waves are coupled into or radiated from the slots 22. That is, the RF signals transmitted and received by the radiating element 12 are transmitted by way of coupling between the first waveguide channels 14 and the slots 22.

With this design of slot structure, after the slots of the carrier 21 are disposed to directly face the first waveguide channels 14, electromagnetic coupling resulting from the RF signal, as a high-frequency signal, is formed between the first waveguide channels 14 and the carrier 21. Under the action of electromagnetic coupling, the RF signal is coupled from one of the first waveguide channels 14 to a corresponding slot 22, or vice versa, for transmission. In this case, since the transmission mode of the RF signal between the first waveguide channels 14 and the slots 22 is a coupling mode, which is different from the guided wave transmission mode supported by the waveguide structure, the slots 22 no longer need to satisfy the structural requirement under the guided wave transmission mode, namely that the opening of a slot 22 has the same size as that of the waveguide port of a first waveguide channel 14. Therefore, compared with providing a waveguide structure on the carrier, defining the slots 22 on the carrier 21 requires less space to be occupied on the carrier 21, and the transmission of the RF signal is not affected.

In the present embodiments, using a rectangular waveguide as a reference, the aspect ratio of a slot 22 on the carrier 21 is much greater than the aspect ratio of the waveguide port of a conventional rectangular waveguide, such as the one labeled 04 in FIG.1.

In some embodiments, the second surface S2 and the third surface S3 are parallel to metal layers in the carrier 21.

Typically, as shown in FIG. 1, in the conventional solution of transitioning from the chip package 01 to the external waveguide, the waveguide structure in the chip package 01 has the same dimension as the waveguide port of the waveguide channel 04 on the PCB 03, and the waveguide port of the waveguide channel 04 on the PCB 03 also has the same dimension as the external waveguide structure, which results in a relatively large area of the chip package 01. Compared with the waveguide dimensions of the waveguide channel 04 on the PCB 03 in the related technology, the dimensions of the slots 22 on the carrier 21 can be reduced, and the size of the cavity surrounded by the corresponding solder balls 13 is also correspondingly reduced, so that the package dimension of the chip package 11 can be further reduced.

By changing the transmission mode of the RF signal between the first waveguide channels and the slots, that is, transmitting in a slot coupling mode, the dimension of the chip package can be reduced while realizing the transmission and reception of the RF signal, wherein the transition solution of replacing conventional waveguide transmission with slot coupling on the carrier has a smaller size, so that the package dimension of the chip package can be reduced.

In some embodiments, as shown in FIG. 2 and FIG. 3 (FIG. 3 is a top view observed downward from the plane defined by the solder balls 13 in FIG. 2), the radio frequency device may further include a waveguide structure 31 interfaced with the third surface S3 of the carrier 21. A respective second waveguide channel 32 corresponding to each of the slots 22 is defined in the waveguide structure 31. The RF signal is also transmitted by way of coupling between the second waveguide channels 32 and the slots 22.

In some embodiments, to facilitate the alignment between the slots on the carrier 21 and the external waveguide and to couple the RF signal in the slots to the external waveguide, a section of waveguide structure may be additionally provided at each of the slots. This additional waveguide structure has the same dimensions as the waveguide port of the external waveguide and is configured to align with the external waveguide, thereby transmitting the RF signal in the slots to the external waveguide. That is, a waveguide structure 31 is additionally provided on the third surface S3 of the carrier 21. After the waveguide structure 31 is interfaced to the third surface S3, a respective second waveguide channel 32 corresponding to each of the slots 22 is provided. The cross-sectional area of the waveguide port of the respective second waveguide channel 32 is larger than the cross-sectional area of a slot, and the dimension of the waveguide port of the respective second waveguide channel 32 matches the dimension of the waveguide port of the external waveguide structure, so as to facilitate alignment with the external waveguide structure while ensuring a reduced package dimension. Similarly, the RF signal is also transmitted by way of coupling between the second waveguide channels 32 and the slots 22.

In this way, through the slots 22 on the carrier 21, coupling transmission of the RF signal respectively between the slots 22 and the first waveguide channels 14 and between the slots 22 and the second waveguide channels 32 can be realized, thereby realizing the transmission of the RF signal between the first waveguide channels 14 and the second waveguide channels 32. Moreover, this RF signal transmission mechanism can support the first waveguide channels 14 having dimensions different from those of the second waveguide channels 32. For example, to further reduce the package dimension of the chip package 11, the dimensions of the first waveguide channels 14 may be made as small as possible to match the dimensions of the slots 22. Meanwhile, to enable the waveguide structure 31 to better align with the external waveguide structure, the dimensions of the second waveguide channels 32 may be designed to match the dimensions of the external waveguide structure, that is, be the same as the dimension of the external waveguide structure. In this way, a better transition effect of RF signal transmission between the chip package 11 and the external waveguide structure can be achieved.

In some embodiments, a respective one of the slots 22 has a length greater than or equal to λ/2, where λ is the wavelength of the RF signal propagating in the medium within the respective slot 22. This configuration is intended to ensure the effectiveness of transmission of the RF signal within the respective slot 22. As the medium within the respective slot 22 varies, the actual dimension corresponding to 1/2λ also varies. In actual processing, the medium within the respective slot 22 may be adjusted to meet specific dimensional requirements.

For example, when the length of the respective slot 22 is less than 1/2 of the wavelength of the RF signal transmitted in air, the respective slot 22 is further filled with a non-air medium, and the length of the respective slot 22 is greater than or equal to 1/2 of the wavelength of the RF signal propagating in the medium within the respective slot 22.

In some embodiments, when the length of the respective slot 22 cannot reach 1/2 of the wavelength of the RF signal transmitted in air, a non-air medium needs to be additionally filled in the respective slot 22, so that the length of the respective slot 22 is equivalently greater than or equal to 1/2 of the wavelength of the RF signal propagating in the slot 22. For example, a portion of the dielectric layers in the carrier 21 may be retained in the slots 22 to serve as the filled non-air medium.

In some embodiments, a cross-section of each slot 22 has an area smaller than an area of the cross-section of a respective first waveguide channel 14 and an area of a cross-section of a respective second waveguide channel 32.

Since the RF signal transmission is achieved through coupling between the slots 22 and the first waveguide channels 14 and between the slots 22 and the second waveguide channels 32, designing the cross-section dimension of each slot 22 to be smaller than the area of the cross-section of a respective first waveguide channel 14 and the area of the cross-section of a respective second waveguide channel 32 can more easily realize coupling transmission.

In some embodiments, each slot 22 is disposed to directly face a waveguide port of a respective first waveguide channel 14 and a waveguide port of a respective second waveguide channel 32.

By disposing each slot 22 to directly face a waveguide port of a respective first waveguide channel 14 and a waveguide port of a respective second waveguide channel 32, the coupling transmission effect of the RF signal between the slots 22 and the first waveguide channels 14 and between the slots 22 and the second waveguide channels 32 can be effectively ensured, respectively. Moreover, the waveguide ports of the first waveguide channels 14 can also be disposed to directly face the waveguide ports of the second waveguide channels 32 to achieve a better alignment effect.

In some embodiments, the at least one radiating element 12 may be at least one metal patch.

In some embodiments, at least one of the first waveguide channels 14 and the second waveguide channels 32 is rectangular waveguides.

In some embodiments, when both the first waveguide channels 14 and the second waveguide channels 32 are rectangular waveguides, the long side of a respective slot 22 may be parallel to the long side of a rectangular waveguide. In this way, while the dimensions of the slots 22 satisfy the minimized requirement, the dimensions of the first waveguide channels 14 can be also minimized, which is more conducive to reducing the package dimension of the chip package 11.

In some embodiments, the shape of the slots 22 may be, but is not limited to, rectangular or triangular.

In some embodiments, the width of a respective slot 22 is 0.4 mm.

In some embodiments, the length of a respective slot 22 is 1.8 mm and the width of the respective slot 22 is 0.4 mm, and the length of a respective rectangular waveguide is 2.4 mm and the width of the respective rectangular waveguide is 1 mm.

In some embodiments, as described by the radio frequency device of FIG. 2, when the first waveguide channels 14 and the second waveguide channels 32 are both rectangular waveguides with waveguide port dimensions of 2.6 mm × 1.2 mm, and the dimensions of the slots 22 are only 2 mm × 0.4 mm, the corresponding simulation performance is shown in FIG. 4, where a return loss of -10 dB or lower covers 76-81 GHz in the 77 GHz frequency band. It can be seen that the transition structure in the radio frequency device according to the embodiments is applicable to RF signals with a relatively wide transmission bandwidth and has a compact structure, which can serve as a miniaturized package-to-waveguide transition solution and effectively reduce the package area. In the simulation result shown in FIG. 4, the horizontal axis represents the frequency of the RF signal transmitted and received by the radiating element 12 in gigahertz (GHz). The vertical axis represents, in decibels (dB), the return loss (S11 in FIG. 4) of the RF signal transmitted and received by the radiating element 12. The RF signal propagates through the first waveguide channels 14, the slots 22, and the second waveguide channels 32.

From the above, it can be found that the radio frequency device provided in the embodiments of the present disclosure can effectively reduce the area on the carrier occupied by the transition structure while ensuring that the transition structure does not significantly affect the transmission performance of the RF signal.

Some embodiments of the present disclosure provide a wireless device, including: the radio frequency device as described in the preceding embodiments; and an antenna disposed on the carrier of the radio frequency device and configured to transmit and receive wireless signals.

The radio frequency device is connected to an external waveguide antenna and configured to transmit and receive RF signals.

The radio frequency device is connected to the antenna through a first transmission line and configured to transmit and receive wireless signals. The carrier may be a PCB, and the first transmission line may be a PCB trace. In addition, the radio frequency device may be integrated with the antenna as an integral device, forming structures such as AiP (Antenna in Package), AoP (Antenna on Package), or AoC (Antenna on Chip).

Some embodiments of the present disclosure provide a terminal device, including: a device body; and the wireless device as illustrated in the preceding embodiments. The wireless device is disposed on the device body, and the wireless device is configured for at least one of target detection and communication.

In some embodiments of the present disclosure, the wireless device may be disposed outside the device body. In some other embodiments of the present disclosure, the wireless device may be disposed inside the device body. In still some other embodiments of the present disclosure, the wireless device may have a portion disposed inside the device body and another portion disposed outside the device body. The present disclosure does not impose any limitation on this, and the specific arrangement depends on actual circumstances.

It should be noted that functions of the wireless device such as target detection and communication may be realized by transmitting and receiving signals.

In some embodiments, the device body may be a component or product applied in fields such as smart housing, transportation, smart home, consumer electronics, surveillance, industrial automation, in-cabin detection, and healthcare. For example, the device body may be a smart transportation device (such as an automobile, a bicycle, a motorcycle, a ship, a subway, a train, etc.), a security device (such as a camera), a smart wearable device (such as a wristband, glasses, etc.), a smart home device (such as a television, an air conditioner, a smart lamp, etc.), various communication devices (such as a mobile phone, a tablet computer, etc.), as well as a gate, a smart traffic indicator, a smart signboard, a traffic camera, and various industrial robotic arms (or robots). The device body may also be various instruments for detecting vital sign parameters and various apparatuses equipped with such instruments. The wireless device may be the wireless device as illustrated in the present disclosure. The structure and working principle of the wireless device have been described in detail in the above embodiments and are not repeated herein.

The technical features of the above embodiments may be combined in any manner. For the sake of concise description, not all possible combinations of the various technical features in the above embodiments have been described. However, as long as the combinations of these technical features are not contradictory, they shall be considered as within the scope described in this specification.

It shall be understood by a person of ordinary skill in the art that the above embodiments are specific implementations for realizing the present disclosure. In practical applications, various changes may be made in form and details without departing from the spirit and scope of the present disclosure.

## Claims

1. A radio frequency device, comprising:
a chip package having a first surface, wherein at least one radiating element is disposed on the first surface, and a respective first waveguide channel is formed on the first surface and configured to surround each of the at least one radiating element; and
a carrier having second and third surfaces opposite to each other, wherein the second surface is configured to be interfaced with the first surface, and a slot penetrating through the second surface and the third surface and corresponding to the respective first waveguide channel is defined on the carrier.

2. The radio frequency device according to claim 1, further comprising:
a waveguide structure interfaced with the third surface of the carrier;
wherein a respective second waveguide channel corresponding to the slot is defined on the waveguide structure.

3. The radio frequency device according to claim 1 or claim 2, wherein the slot has a length greater than or equal to λ/2, and λ is a wavelength of a radio frequency signal propagating in a medium within the slot.

4. The radio frequency device according to claim 2, wherein a cross-section of the slot has an area smaller than an area of a cross-section of the respective first waveguide channel and an area of a cross-section of the respective second waveguide channel.

5. The radio frequency device according to claim 2, wherein the slot is disposed to directly face a waveguide port of the respective first waveguide channel and a waveguide port of the respective second waveguide channel.

6. The radio frequency device according to any one of claims 1 to 5, wherein the at least one radiating element is at least one metal patch.

7. The radio frequency device according to claim 2, wherein at least one of the respective first waveguide channel and the respective second waveguide channel is a rectangular waveguide, and the slot has a long side parallel to a long side of a waveguide port of the rectangular waveguide.

8. A wireless device, comprising:
the radio frequency device according to any one of claims 1 to 7; and
an antenna disposed on the carrier of the radio frequency device and configured to transmit and receive wireless signals.

9. A terminal device, comprising:
a device body; and
the wireless device according to claim 8, wherein the wireless device is disposed on the device body, and the wireless device is configured for at least one of target detection and communication.
